# EUROPEAN PATENT SPECIFICATION

(11) **EP 0 556 851 B1**
(45) Date of publication and mention of the grant of the patent: **21.08.1996**
(21) Application number: 93102674.4
(22) Date of filing: 19.02.1993
(51) Int. Cl.: B21B 15/00

(54) **Method of splicing metal webs**
Verfahren zum Verbinden von Metallgewebe
Procédé pour joindre de tissu métallique

(30) Priority: 21.02.1992 JP 69945/92
(43) Date of publication of application: 25.08.1993
(73) Proprietor: FUJI PHOTO FILM CO., LTD., Kanagawa (JP)
(72) Inventor: Sawada, Hirokazu, c/o Fuji Photo Film Co., Ltd., Haibara-gun, Shizuoka (JP); Matsuki, Masaya, c/o Fuji Photo Film Co., Ltd., Haibara-gun, Shizuoka (JP)
(74) Representative: Grünecker, Kinkeldey, Stockmair & Schwanhäusser Anwaltssozietät

(56) References cited:
- EP-A- 0 354 574
- EP-A- 0 381 115
- PATENT ABSTRACTS OF JAPAN vol. 8, no. 116 (M-299)1984 & JP-A-59 024 526 ( FUJI SHASHIN film )
- PATENT ABSTRACTS OF JAPAN vol. 5, no. 147 (M-88)1981 & JP-A-56 77 009 ( SUMITOMO KINZOKU KOGYO )
- PATENT ABSTRACTS OF JAPAN vol. 10, no. 109 (M-472)1986 & JP-A-60 240 304 ( ISHIKAWAJIMA HARIMA JUKOGYO )
- PATENT ABSTRACTS OF JAPAN vol. 8, no. 270 (M-344)1984 & JP-A-59 141 303 ( SUMITOMO KINZOKU KOGYO )

## Description

This invention relates to a method of splicing metal webs such as an aluminum substrate and particularly continuously moving metal webs on which a light-sensitive coating composition is to be coated.

### BACKGROUND OF THE INVENTION

In splicing metal webs, such as aluminum substrates on which a light-sensitive coating composition is to be coated, known splicing techniques for preventing a break during the processing steps of the metal webs including a coating step comprise (1) as shown in Fig. 4 of the accompanying drawing, a method in which a substrate is lapped over another (a preceding substrate 1 and a succeeding substrate 2) with their moving direction being the same as the direction of the rotation of a brushing head, and the two substrates are spliced at the lap by at least one ultrasonic welded zone 7 extending over the entire width and double-surface adhesive tape-adhered zone 6 (JP-A-59-24526, the term "JP-A" as used herein means an "unexamined published Japanese patent application") and (2) as shown in Fig. 5, a splicing apparatus comprising a rolling roller composed of a pressing means and a protruding means whose radius is greater than that of the pressing means, the rolling roller being applied to a welded butt splice or a welded small lap of a preceding substrate 1 and a succeeding substrate 2 in such a manner that the metal web is held down under the pressing means while welded joint area 3 is rolled under the protruding means (JP-A-U-62-179116, the term "JP-A-U" as used herein means an "unexamined published Japanese utility model application").

In order to prevent entrapment of air bubbles during coating on the joint area, (3) a splicing apparatus having the above-described structure in which the difference in level between the protruding means and the pressing means of the rolling roller is tapered or curved has been proposed in U.S.-A-5,074,457 (which corresponds to JP-A-3-8575 and EP-A-0 354 574). Document EP-A-0 354 574 discloses a method according to the precharacterising part of the claim.

However, the above-described techniques (1) and (2) involve entrapment of air bubbles on coating of a light-sensitive coating composition at the part with a difference in level 4, 5 or 10 and also cause coating streaks in that area. In the production of lithographic printing plates, for example, such coating streaks result in a quality rejection thereby reducing the yield. Technique (3), while developed to eliminate the above problem, turned out to still cause coating streaks depending on the angle of tapering.

### SUMMARY OF THE INVENTION

An object of the present invention is to provide a method of splicing metal webs where streaking on coating does not occur and to which any conventional splicing technique is applicable.

The object of the present invention is accomplished by a method of splicing continuously moving metal webs according to the claim

### BRIEF DESCRIPTION OF THE DRAWINGS

Fig. 1 shows a cross-section of a lap splice area formed during a method embodying the present invention.

Fig. 2 shows a cross-section of a butt splice area formed during a method according to another embodiment of the present invention.

Fig. 3 illustrates a method of coating a metallic substrate.

Fig. 4 is a cross section of a lap splice area according to a conventional splicing method.

Fig. 5 is a cross section of a butt splice area according to a conventional splicing method.

### DETAILED DESCRIPTION OF THE INVENTION

The joining method according to the present invention includes both lap splicing and butt splicing.

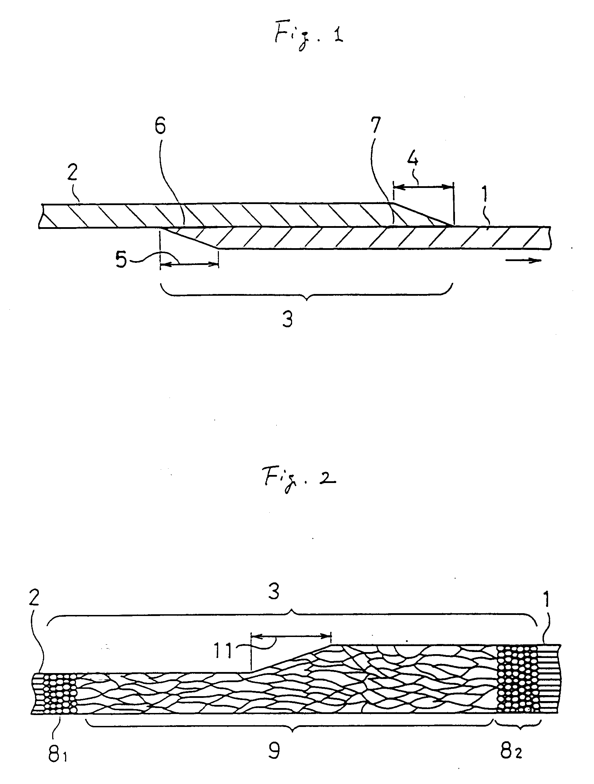

In the case of lap splicing, the difference in level in a splice area occurs in two areas, one at the area where the leading end of succeeding substrate 2 is lapped over preceding substrate 1 (indicated by numeral 4 in Fig. 1) and the other at the area where the rear end of preceding substrate 1 is lapped over succeeding substrate 2 (indicated by numeral 5 in Fig. 1).

In the case of butt splicing, the difference in level occurs at one area where preceding substrate 1 and succeeding substrate 2 meet.

To smoothly taper the level difference in the splice area at an angle of 20° or less means that the splice area has a smooth and even surface with no difference in level or at least a tapered surface of 20° or less if there is any difference in level. If the splice area is not smooth or has an angle of tapering of more than 20°, streaks tend to be produced on coating.

Any desired angle of tapering of 20° or less can be obtained in a conventional manner. For example, a specific angle of tapering can be obtained by the tapered angle of the tapering rolling rollers used. When the splicing areas are tapered before splicing, the angle of tapering can be determined by varying a rolling processing condition or cutting processing condition to be used for tapering the web.

Coating streaks tend to occur if the splice area has an angle of tapering of 45°, even more so at 90°. A mildly tapered surface may be formed by, for example, rolling with a tapered roll as described in U.S.-A-5,074,457 which corresponds to JP-A-3-8575 and EP-A-0 354 574.

Preferred embodiments of the present invention are explained by reference to the accompanying drawings.

Fig. 1 illustrates one example of a lap splice formed by the splicing method including the present invention. Where succeeding substrate 2 is lapped over preceding substrate 1, splice area 3 has two differences in level, 4 and 5. Splice area 3 comprises double-surface adhesive tape-adhered zone 6 and ultrasonic welded zone 7. Level differences 4 and 5 are rolled under a tapered roll so that the angle of tapering of not more than 20° is achieved.

Fig. 2 illustrates one example of a butt splice formed by the splicing method of the present invention. Where preceding substrate 1 and succeeding substrate 2 are butted or slightly lapped over each other, and the joint is welded, splice area 3 is composed of fused area 9 and, in front and rear of fused part 9, area 8₁, 8₂ which is affected by heat. The splice area is rolled under the above-described tapered roller to form tapered area 11 with an angle of tapering of 20° or less.

The splicing method of the present invention is applied to the production of a presensitized lithographic printing plate, which comprises, for example, soaking a 2S aluminum plate having a thickness of, e.g., 0.15 mm in a 10% aqueous solution of sodium tertiary phosphate kept at 80°C for 3 minutes for degreasing, graining the surface of the aluminum plate with a nylon brush, etching the surface of the grained aluminum substrate in a sodium aluminate etching solution at 60°C for about 10 seconds, desmutting the surface with a 3% aqueous solution of sodium hydrogensulfate, subjecting the aluminum substrate to anodizing in 20% sulfuric acid at 2 A/dm² for 2 minutes, treating the anodized film with a 2.5% aqueous solution of sodium silicate at 70°C for 1 minute, and coating a light-sensitive coating composition on the thus prepared aluminum substrate. These steps are carried out on a continuously moving aluminum web.

The splicing of the metal webs can be achieved using an accumulator while discontinuing the movement of the web near the splicing area. However, the accumulated web comes out continuously from the accumulator during the time of splicing of web, the web can be coated continously with the light-sensitive coating composition.

In a preferred embodiment of the present invention, the present invention is directed to a method for producing a lithographic printing plate material comprising the steps of splicing continuously moving metal webs adjusting the difference in levels in the splice area to be smoothly tapered at an angle of 20° or less, coating a light-sensitive coating composition on the spliced metal web, and drying the coated layer on the spliced metal web.

Light-sensitive coating compositions which can be used in the above-described presensitized printing plate include negative working light-sensitive compositions which are insolubilized by the action of active radiation and positive working light-sensitive compositions. Examples of suitable negative working light-sensitive compositions are a combination of a diazo resin and shellac (JP-A-47-24404), a combination of polyhydroxyethyl methacrylate and a diazo resin, a combination of a diazo resin and a soluble polyamide resin (U.S.-A-3,751,257), a combination of a light-sensitive azide compound and an epoxy resin (U.S.-A-2,852,379), a light-sensitive azide compound, a diazo resin; a light-sensitive resin having an unsaturated double bond, in the molecule thereof which dimerizes on irradiation with actinic radiation to become insoluble, such as polyvinyl cinnamate derivatives described in GB-A-843,545 and GB-A-966,297 and U.S.-A-2,725,372; a light-sensitive polyester obtained by condensation between bisphenol A and divanillalcyclohexanone or between p-phenylene diethoxyacrylate and 1,4-di-β-hydroxyethoxycyclohexanone as described in CA-A-696,997; a prepolymer of diallyl phthalate as described in U.S.-A-3,462,267; and a light-sensitive composition comprising an ethylenically unsaturated compound having at least two unsaturated double bonds in the molecule thereof which undergoes polymerization on irradiation with actinic radiation an unsaturated ester of a polyol as described in JP-B-35-8495 (the term "JP-B" as used herein means an "examined published Japanese patent application") (e.g., ethylene di(meth)acrylate, diethylene glycol di(meth)acrylate, glycerol di(meth)acrylate, glycerol tri(meth)acrylate, 1,3-propylene di(meth)acrylate, 1,4-cyclohexanediol (meth)acrylate, 1,4-benzenediol di(meth)acrylate, pentaerythritol tetra(meth)acrylate, 1,3-propylene glycol di(meth)acrylate, 1,5-pentanediol di(meth)acrylate, pentaerythritol tri(meth)acrylate, and bis(meth)acrylate of polyethylene glycol (50 to 500)), or an unsaturated amide, particularly an α-methylenecarboxylic acid amide and more particularly an α,ω-diamide and an amide of a ω-diamine containing therein oxygen (e.g., methylenebis(meth)acrylamide and diethylenetriamine tris(meth)acrylate), divinyl succinate, divinyl adipate, divinyl phthalate, divinyl terephthalate, divinylbenzene-1,3-disulfonate, and an appropriate binder, such as a derivative of polyvinyl alcohol or cellulose having a carboxyl group in the side chain thereof (e.g., polyvinyl hydrogen phthalate or carboxymethyl cellulose) or a methyl methacrylate-methacrylic acid copolymer. Examples of suitable positive working light-sensitive compositions include an o-diazo-oxide type light-sensitive compound as described in U.S.-A-3,635,709, US-A-3,061,430, and US-A-3,061,120, a phosphotungstate of a diazo resin (JP-B-39-7663), a yellow prussiate of a diazo resin (U.S. -A-3,113,023), and a light-sensitive composition comprising a diazo resin and polyvinyl hydrogen phthalate (Japanese Patent Application No. Sho-40-18812). Further, light-sensitive compositions containing a linear polyamide and a monomer having an addition polymerizable unsaturated bond as described in U.S.-A-3,081,168, US-A-3,486,903, US-A-3,512,971, and US-A-3,615,629 are also useful.

Particularly useful light-sensitive compositions include a composition comprising a diazo resin and shellac as disclosed in JP-A-47-24404, a composition comprising a diazo resin and a hydroxyethyl methacrylate copolymer as disclosed in JP-A-50-118802, and a composition comprising an esterification product between naphthoquinonediazidesulfonic acid and pyrogallol-acetone resin and a novolak resin.

These light-sensitive compositions are usually adjusted to have a viscosity of from 1 to 10 cps. Drying of the coating is effected using heated air at a temperature of from 30° to 200°C, and preferably from 40° to 140°C. The drying temperature may be kept constant or increased stepwise.

In some cases, use of dehumidified air for drying brings about advantageous results. Heated air is suitably supplied to the coating at a rate of from 0.1 to 30 m/sec, and preferably from 0.5 to 20 m/sec.

The present invention is now illustrated in greater detail by reference to the following Examples, but it should be understood that the present invention is not to be construed as being limited thereto.

### EXAMPLE 1

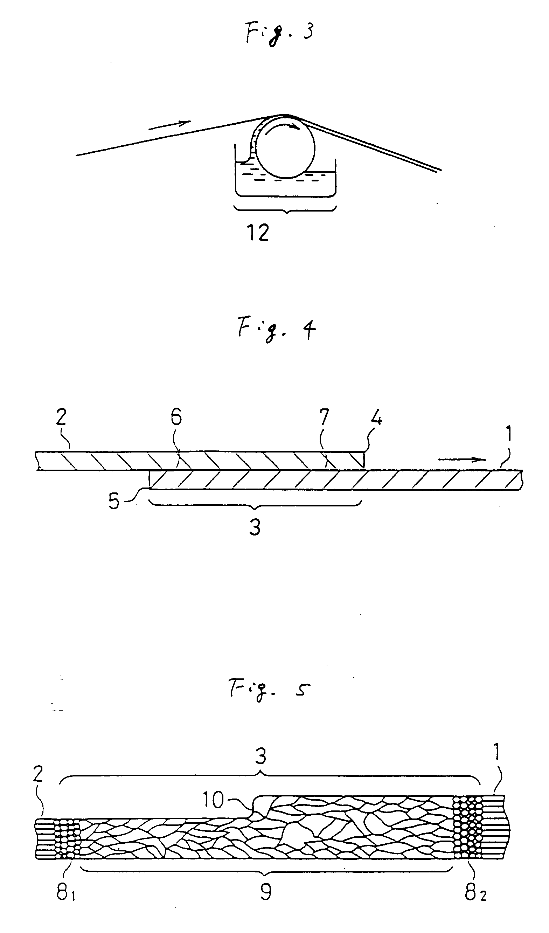

As shown in Fig. 1, two aluminum plates of the same thickness (0.3 mm) were spliced with a lap of 50 mm using double-surface adhesive tape-adhered zone 6 and ultrasonic welded zone 7, and splice area 3 was rolled using a rolling roller to make the differences in level 4 and 5 smoothly tapered at an angle of 20°. A coating composition was coated on the spliced aluminum plates by using a rod coater 12 as shown in Fig. 3. For comparison, the same coating composition was similarly coated on a conventional lap splice as shown in Fig. 4. The joint according to the present invention did not have any coating streaks, while conventional joints having level differences had coating streaks, resulting in a great reduction in yield.

### EXAMPLE 2

As shown in Fig. 2, a 0.3 mm thick aluminum plate as a preceding substrate and a 0.15 mm thick aluminum plate as a succeeding substrate were spliced with a lap of 1.5 mm. The splice area was welded using RF pulse arc welding, and a rolling roller composed of a pressing means and a protruding means having a greater radius than that of the pressing means with the difference in level between the two means having (1) an angular shape (no taper) or being tapered at an angle of (2) 45°, (3) 20°, or (4) 5° was applied thereon. Fused area 9 and thermally affected areas 8₁, 8₂ at both ends of fused area 9 which had resulted from the welding, the rear end of preceding substrate 1, and the leading end of succeeding substrate 2, were simultaneously press-rolled so that the tapered shape of the roller (angular shape in the case of (1)) was transferred to the splice area having a difference in level while adjusting the difference in plate thickness among thermally affected areas 8₁, 8₂, fused area 9, preceding substrate 1, and succeeding substrate 2 to be within 30%. A light-sensitive coating composition was coated on the spliced material using a rod coater as shown in Fig. 3. The spliced material rolled under the rolling roller (1) or (2) showed coating streaks, resulting in a reduced yield, while that rolled under the rolling roller (3) or (4) did not show coating streaks and produced a satisfactory product.

According to the method of the present invention, spliced materials free from coating streaks can be produced in good yield.

While the invention has been described in detail and with reference to specific examples thereof, it will be apparent to one skilled in the art that various changes and modifications can be made therein without departing from the scope thereof, as defined in the claim.

## Claims

1. A method for producing a lithographic printing plate material comprising the steps of splicing continuously moving metal webs, adjusting the difference in levels in the splice area to be smoothly tapered, coating a light-sensitive coating composition on the spliced metal web, and drying the coated layer on the spliced metal web, characterised in that the taper angle is 20° or less and a rod coater is used for coating.

## Patentansprüche

1. Verfahren zur Herstellung eines lithographischen Druckplattenmaterials umfassend die Schritte des Verbindens sich kontinuierlich bewegender Metallbänder, Einstellen des Höhenunterschiedes der Verbindungsfläche, um keilartig ineinander überzugehen bzw. verjüngt zu werden, Aufbringen einer lichtempfindlichen Beschichtungs-zusammensetzung auf die verbundenen Metallbahnen und Trocknen der Beschichtung auf den verbundenen Metallbahnen, dadurch gekennzeichnet, daß der Verjüngungswinkel bzw. der Übergangswinkel 20° oder weniger beträgt und das ein Stab- bzw.Walzbeschichter für die Beschichtung verwendet wird.

## Revendications

1. Procédé pour produire un matériau pour plaque d'impression lithographique comprenant les étapes consistant à joindre des bandes métalliques qui se déplacent de manière continue, ajuster la différence de niveau dans la zone de jonction de manière qu'elle diminue sans inégalité, appliquer en revêtement une composition de revêtement sensible à la lumière sur la bande métallique jointe et sécher la couche appliquée en revêtement sur la bande métallique jointe, caractérisé en ce que l'angle de diminution est de 20° ou moins et un applicateur à barre est utilisé pour le revêtement.
